(19) Europäisches Patentamt
European Patent Office
Office européen des brevets

(11) **EP 3 380 929 B1**

(12) **EUROPEAN PATENT SPECIFICATION**

(45) Date of publication and mention
of the grant of the patent:
**13.09.2023 Bulletin 2023/37**

(51) International Patent Classification (IPC):
**G05B 13/02** *(2006.01)* **G06F 9/44** *(2018.01)*
**H01F 27/08** *(2006.01)* **H01F 27/33** *(2006.01)*

(21) Application number: **15909083.6**

(22) Date of filing: **27.11.2015**

(52) Cooperative Patent Classification (CPC):
**H01F 27/08; G05B 13/021; H01F 27/33**

(86) International application number:
**PCT/CN2015/095788**

(87) International publication number:
**WO 2017/088172 (01.06.2017 Gazette 2017/22)**

(54) **METHOD AND SYSTEM FOR CONTROLLING COOLING SYSTEM OF POWER EQUIPMENT**

VERFAHREN UND SYSTEM ZUR STEUERUNG EINES KÜHLSYSTEMS EINER ENERGIEANLAGE

PROCÉDÉ ET SYSTÈME DE COMMANDE D'UN SYSTÈME DE REFROIDISSEMENT D'UN ÉQUIPEMENT DE PUISSANCE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**03.10.2018 Bulletin 2018/40**

(73) Proprietor: **Hitachi Energy Switzerland AG
5400 Baden (CH)**

(72) Inventors:
• **CHEN, Yao
Västerås 72209 (SE)**
• **CHEN, Niya
Beijing 100016 (CN)**
• **YU, Rongrong
Beijing 100123 (CN)**

(74) Representative: **Vossius & Partner
Patentanwälte Rechtsanwälte mbB
P.O. Box 86 07 67
81634 München (DE)**

(56) References cited:
**CN-A- 101 968 250     CN-A- 102 890 520
US-A1- 2011 066 298     US-A1- 2014 229 012
US-A1- 2014 297 206     US-B1- 7 953 530**

**Description**

**Technical Field**

The invention relates to control of temperature of a power equipment, and more particularly to control of temperature of a power equipment with digital data processing.

**Background Art**

Power equipment, for example, can be a power transformer, machine and so on, whose losses vary with its loading level, and substantial part of its losses is converted into heat. Due to higher power ratings, power transformers are often cooled by forced-air cooling, forced-oil cooling, water-cooling, or combinations of these. Therefore, the power equipment needs a cooling system which, for example, can be an arrangement of at least one fan or blower pumping cooling-air or liquid coolants as oil and water. The practice of slowing down or speeding up cooling system to keep temperature of a power equipment within a predetermined range is common and there are numerous technologies that accomplish this.

An operation efficiency of the power equipment is influenced by several parameters, such as the costs related to power lose, life lose and noise-reduction. To optimize the power equipment operation efficiency as an objective for optimization-based design, these parameters have to be adjusted with conflicting constraints. For example, normally, lower winding temperature leads to the lower copper loss of winding. However, the power consumption of the cooling system will be higher at the same time, meaning that the overall efficiency, considering both transformer winding and the cooling system itself, might be less optimal. Besides efficiency, the variation of the winding temperature is also one key factor which will affect the lifecycle of the transformer. The more frequent the temperature varies, the faster the transformer aging will be. It could be so that the efficiency of the transformer is optimized, however at a cost of shortened transformer lifetime. For transformer operated at urban area, noise level is also one important criterion to consider in order to reduce the impact on the neighbouring residents especially at night.

A variable speed cooling system controller has been developed that is intended for optimization of the operation efficiency of the power transformer. One example is described in Pat. WO 2015/058354, wherein the concept of objective optimization considering the constraints of its power loss, life loss and noise for transformer cooling control has been disclosed. The solution involves preprocessing the initial data input by user; collecting the on-line data, and based on a quantitative model according to criteria specified for a time interval, calculating the optimized control command to meet the requirement of the transformer loss, top-oil temperature variation and noise; and executing the control actions by controlling a controllable switch and/or sending a control command to a variable frequency driver activating the cooling system. Such solution enables improving operation efficiency of the transformer by cooling control considering transformer copper loss, motor-fans power consumption and speed regulation of variable frequency drive. With this approach, a computer is used to search for the best cooling control realizing speed regulation for the motor-fan loads selectively with low capital investment on variable frequency drive in an efficient manner.

According to the quantitative model described in Pat. WO 2015/058354, the objective of its criteria to be optimized concerns with the power transformer operation efficiency in a certain time interval of a multiple continuous time intervals consisting of a load cycle. The load cycle can be a period of time, where the loading level of the power equipment appears in a substantially cyclic manner, for example 24 hours. The load cycle can be divided into several time units either with equal length or unequal, for example 24 time intervals each lasting for one hour. This quantitative model only predicts the power transformer operation efficiency respectively in terms of each of the time intervals. However, because the response of interest for previous time intervals will have effect upon the subsequent, separate optimization design based on the quantitative model might not suffice for optimal criteria for an operation efficiency objective concerning a load cycle of a power equipment. For example, the cooling optimization at time interval n might lead to higher initial temperature for time interval n+1. Such temperature difference will accumulate step-by-step for the computation of the response of interest concerning the time intervals of the load cycle subsequent to the initial time interval n, which will gradually increase transformer power loss and life loss. Therefore, even if the optimization algorithm in terms of each of the time intervals can achieve the best result at every time internal, not necessarily the best for an entire load cycle.

US 2011/066298 A1 discloses a control system that performs optimal control of a power plant. During operation, the plant operation is simulated at various different operating points within an optimization process while operating under the current environmental conditions.

**Brief Summary of the Invention**

The present invention is defined by the features of the independent claims. Further preferred embodiments of the present invention are defined in the dependent claims

In particular, according to an aspect of present invention, it provides a method for controlling cooling system of a power equipment, including: obtaining a first data set representing operational cost related parameters specific to the power equipment and its cooling system forecasted for a series of time intervals of present load cycle in consideration of a second data set representing operational condition related parameters for the power equipment forecasted for a series of time intervals of present load cycle; in consideration of the parameters represented by the first data set, through knowledge-based predetermined numerical and/or logical linkages, establishing a third data set representing cooling capacity parameters for the cooling system at the series of time intervals of the present load cycle according to criteria for operational cost optimization of the power equipment and its cooling system for the present entire load cycle; wherein the present load cycle comprises a current time interval and the series of time intervals scheduled afterwards, wherein correlations between different time intervals are considered;
and in the present load cycle, controlling the cooling system to operate at the cooling capacity parameters at the series of time intervals represented by the established third data set.

According to another aspect of present invention, it provides a system for controlling cooling system of a power equipment, which has at least one data processing device, wherein the data processing device is configured for: obtaining a first data set representing operational cost related parameters specific to the power equipment and its cooling system forecasted for a series of time intervals of present load cycle in consideration a second data set representing operational condition related parameters for the power equipment forecasted for a series of time intervals of present load cycle; in consideration of the parameters represented by the first data, through knowledge-based predetermined numerical and/or logical linkages, establishing a third data set representing cooling capacity parameters for the cooling system at the series of time intervals of the present load cycle according to criteria for operational cost optimization of the power equipment and its cooling system for the present load cycle; wherein the present load cycle comprises a current time interval and the series of time intervals scheduled afterwards, wherein correlations between different time intervals are considered; and in the present load cycle, controlling the cooling system to operate at the cooling capacity parameters at the series of time intervals represented by the established third data set.

By considering the correlations between different time intervals into and making the cooling optimization valid not only at the specific time interval but also in an entire load cycle, the cooling capacities in the next at least one load cycle is optimized.

According to an example, disclosed is also a method for controlling cooling system of a power equipment, including: obtaining a first data set representing operational cost related parameters specific to the power equipment and its cooling system forecasted for a series of time intervals of present load cycle in consideration of a second data set and a fourth data set, wherein the second data set represents operational condition related parameters for the power equipment forecasted for a series of time intervals of present load cycle, where the present load cycle comprises current time interval and the series of time intervals scheduled afterwards, and the fourth data set represents operational condition related parameters for the power equipment for the current time interval of the present load cycle; in consideration of the parameters represented by the first data set, through knowledge-based predetermined numerical and/or logical linkages, establishing a third data set representing cooling capacity parameters for the cooling system at the current time interval and the series of time intervals of the present load cycle according to criteria for operational cost optimization of the power equipment and its cooling system for the present load cycle; and during a period in the current time interval of the present load cycle, controlling the cooling system to operate at the cooling capacity parameter of the current time interval represented by the established third data set.

According to an example, disclosed is also a system for controlling cooling system of a power equipment, which has at least one data processing device, wherein the data processing device is configured for: obtaining a first data set representing operational cost related parameters specific to the power equipment and its cooling system forecasted for a series of time intervals of present load cycle in consideration of a second data set and a fourth data set, wherein the second data set represents operational condition related parameters for the power equipment forecasted for a series of time intervals of present load cycle, where the present load cycle comprises current time interval and the series of time intervals scheduled afterwards, and the fourth data set represents operational condition related parameters for the power equipment for the current time interval of the present load cycle; in consideration of the parameters represented by the first data set, through knowledge-based predetermined numerical and/or logical linkages, establishing a third data set representing cooling capacity parameters for the cooling system at the current time interval and the series of time intervals of the present load cycle according to criteria for operational cost optimization of the power equipment and its cooling system for the present load cycle; and during a period in the current time interval of the present load cycle, controlling the cooling system to operate at the cooling capacity parameter of the current time interval represented by the established third data set.

For the present load cycle, the determination of the first data set based on a real-time measurement of ambient temperature and loading ratio for the first time interval in the load cycle is helpful for increasing the accuracy of the first data set in terms of representation of the operational cost related parameter, thus a more accurate cooling optimization approach can be achieved.

## Brief Description of the Drawings

The subject matter of the invention will be explained in more detail in the following text with reference to preferred exemplary embodiments which are illustrated in the drawings, in which:

Figure 1 illustrates a method for controlling cooling system of a power equipment according to an embodiment of present invention; and
Figure 2 illustrates a method for controlling cooling system of a power equipment according to another embodiment of present invention.

The reference symbols used in the drawings, and their meanings, are listed in summary form in the list of reference symbols. In principle, identical parts are provided with the same reference symbols in the figures.

## Preferred Embodiments of the Invention

In the following description, for purposes of explanation and not limitation, specific details are set forth, such as particular circuits, circuit components, interfaces, techniques, etc. in order to provide a thorough understanding of the present invention. However, it will be apparent to one skilled in the art that the present invention may be practiced in other embodiments that depart from these specific details. In other instances, detailed descriptions of well-known methods and programming procedures, devices, and circuits are omitted so not to obscure the description of the present invention with unnecessary detail.

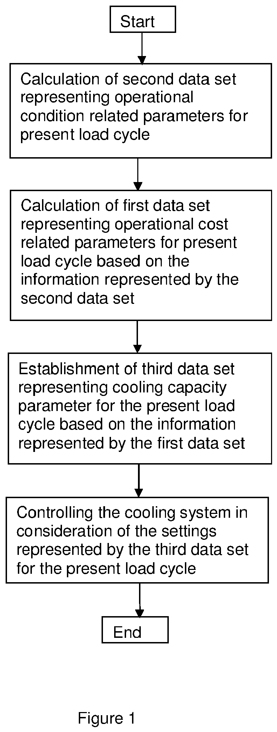

Figure 1 illustrates a method for controlling cooling system of a power equipment according to an embodiment of present invention. For example, the power equipment is a power transformer. As shown in figure 1, both operational cost related parameter *Powerloss, Lifeloss, Noise* and operational condition related parameter *AmbientTemperatur, LoadingLevel* are determined step-by-step. The operational cost related parameter *Powerloss, Lifeloss, Noise* is relating to economic significance of the power equipment and its cooling system forecasted for a series of time intervals of present load cycle, and the operational condition related parameter *AmbientTemperatur, LoadingLevel* is relating to technical status of the power equipment forecasted for a series of time intervals of present load cycle. Cooling capacity parameter *CoolingCapacityParameter* is produced by linking the two above-mentioned operation-related parameters.

For this purpose, a first data set representing the operational cost related parameters *Powerloss, Lifeloss, Noise* and a second data set representing the operational condition related parameters *AmbientTemperature, LoadingLevel* are first obtained for the power equipment and its cooling system. The two obtaining steps can be performed simultaneously, in order no matter which one comes in the first place, or interleave with each other.

In a preprocessing $PP_{condition}$, the operational condition related parameters *AmbientTemperature, LoadingLevel* are obtained, which predict ambient temperature and loading ratio of the power equipment for a series of time intervals of present load cycle. The input data of the operational condition related parameters *AmbientTemperature, LoadingLevel* required for determining estimation of top-oil/hot-spot temperature of the power equipment which is further considered for estimation of the operational cost related parameters *Powerloss, Lifeloss, Noise,* may be estimated based on historical data derived from professional knowledge and/or experience, or as an alternative based on on-line measurements of the ambient temperature. The obtaining step may be performed automatically in combination with appropriately configured database and/or manually input by an operator, or by receiving data representing the ambient temperature. For example, the operational condition related parameters represented by the second data set are output values of a processing of those in history, and the history covers a period of time of previous load cycle. To obtain the operational cost related parameters *Powerloss, Lifeloss, Noise* a series of time intervals of present load cycle, input signals corresponding to the operational cost related parameters *Powerloss, Lifeloss, Noise,* such as estimations of power loss of the power equipment, the power equipment lifecycle cost and noise reduction cost for the cooling system, are obtained. The obtaining step can be performed automatically in combination with appropriately configured database, and/or manually input by an operator.

The input characteristics associated with the operational cost related parameters *Powerloss, Lifeloss, Noise,* usually represent the possible estimations based on professional knowledge and/or experience.

Besides, the above-mentioned operational cost related parameters *Powerloss, Lifeloss, Noise* may be output values of implemented upstream calculation as shown in figure 1, which, for example, are obtained through another preprocessing $PP_{cost}$ of available knowledge and historical data as specified thereafter. These values are then introduced into the method and/or transferred to the system as technical input data, if necessary using appropriately pre-configured interfaces for data detection and/or transmission, for example, via a local area network (LAN) and/or a world area network (WAN), particularly the Internet or a radio network, or as accessible on a data storage, preferably in a database or stored data set.

In consideration of the first data set representing the operational cost related parameters *Powerloss, Lifeloss,*

*Noise,* through knowledge-based predetermined numerical and/or logical linkages, establishing a third data set representing cooling capacity parameters *CoolingCapacityParameter* for the cooling system at the series of time intervals of the present load cycle according to criteria for operational cost optimization of the power equipment and its cooling system for the present load cycle. The preference allocation and/or definition may be performed in this case, for example, by using objective function calculation as described thereafter.

In the present load cycle, controlling the cooling system to operate at the cooling capacity parameters at the series of time intervals represented by the established third data set.

By considering the correlations between different time intervals into and making the cooling optimization valid not only at the specific time interval but also in an entire load cycle, the cooling capacities in the next at least one load cycle is optimized.

Objective function calculation

The optimization objectives include: power loss of both transformer and cooling system, lifetime loss of transformer, and noise emission from cooling fans, as expressed by the following equations, where n represents the time internal for cooling optimization.

$$\begin{cases} f1(n) = Powerloss\_TX(n) + Powerloss\_CO(n) \\ f2(n) = Lifeloss\_TX(n) \\ f3(n) = Noise\_CO(n) \end{cases} \tag{1}$$

*TX* is transformer-related, and *CO* is cooling-system-related.

These three objectives can all be regarded as a function of cooling capacity that put into operation.

In order to unify these three objectives into one, other three parameters should be introduced as: electricity price, transformer lifecycle cost, and noise reduction cost.

Therefore these three factors can be turned into money and thus be unified together, as shown in the equation below.

$$\begin{aligned} f(n) = \\ f1(n) \times power\ loss\ cost\ + \\ f2(n) \times transformer\ lifeloss\ cost\ + \\ f3(n) \times noise\ reduction\ cost \end{aligned} \tag{2}$$

In order to realize the operational cost reduction during the whole load cycle, the objective function should be designed as shown in below, where F(n) is the final optimization target, which is the summation of the operational cost during a whole load cycle, i.e. 24 hours.

$$\begin{aligned} Obj\ Func = \min(F(n)) \\ F(n) = f(n) + f(n+1) + f(n+2) + \dots + f(n+N),\ N = 24 \end{aligned} \tag{3}$$

In the present load cycle, the cooling system is controlled to operate at the cooling capacity parameters *CoolingCapacityParameter* at the series of time intervals represented by the established third data set.

The load cycle-oriented and systematically structured procedure according to the method is performed in this case, using a computer automatically searching for the best design according to criteria that is specified as above. This allows to achieve the minimum operational cost for power transformer during an entire load cycle by a compromise of several conflicting constraints as:

- Energy efficiency improvement of the entire transformer system
- Lifetime extension and reduced maintenance of transformer
- Cooling system noise reduction.

Power loss, lifecycle loss and noise level determination

The determination of the first data set representing the operational cost related parameters *Powerloss, Lifeloss, Noise* may be performed in this case, for example, by the calculation as below. Transformer copper loss will be a function of cooling capacity because the winding resistance will be different at different winding temperature. As expressed in equation (4), the copper loss $P_{TR}$ can be calculated by using the rated load loss $P_{TRN}$, the load factor K, the temperature coefficient of resistance of winding $\alpha$ (for copper winding, $\alpha$=0.00393), and the average winding temperature $\overline{\theta_w}$.

$$P_{TR}(n) = K(n)^2 \frac{1 + \alpha \overline{\theta_w}(n)}{1 + 75\alpha} P_{TRN} \qquad (4)$$

The power loss of cooling system can be represented by equation (5), where $P_{CON}$ is the rated power of motor-fan for cooling. With variable frequency drives, the power consumption will be cubic to the air flow out of cooling fans; without variable frequency drives, the power consumption will be proportional to the number of motor-fans that are put into operation.

$$\begin{cases} P_{CO}(n) = X(n) \times P_{CON}, & without \quad VFD \\ P_{CO}(n) = X^3(n) \times P_{CON}, & with \quad VFD \end{cases} \qquad (5)$$

The life loss of transformer can be calculated by using the aging rate which is a function of top-oil/hot-spot temperature and the types of insulation paper, as shown in equation (6)

$$V(n) = \begin{cases} 2^{(\theta_h(n)-98)/6} \\ e^{\left(\frac{15000}{110+273} - \frac{15000}{\theta_h(n)+273}\right)} \end{cases} \qquad (6)$$

Total noise from transformer $TRN_{ctrl}$ system can be calculated by using equation (7), where $TRN_1$ is the noise from transformer at ONAN condition, $CFN_{ctrl}$ is the noise from the cooling fans which are controlled by the optimal cooling strategy.

$$TRN_{ctrl}(n) = \begin{cases} TRN_1 + 10\lg\left(1 + 10^{-\frac{TRN_1 - CFN_{ctrl}(n)}{10}}\right), TRN_1 > CFN_{ctrl}(n) \\ CFN_{ctrl}(n) + 10\lg\left(1 + 10^{-\frac{CFN_{ctrl}(n) - TRN_1}{10}}\right), CFN_{ctrl}(n) \geq TRN_1 \end{cases} \qquad (7)$$

Assume the noise from transformer at ONAF condition when all the cooling fans are in operation is $TRN_2$, the total number of motor-fan branches is $num_{fan}$, and X is the cooling capacity put into operation, then $CFN_{ctrl}$ can be calculated as below if no VFD is installed:

$$\begin{cases} CFN_{ctrl}(n) = CFN - 10\lg(num_{fan}) + 10\lg\left(\frac{X(n) \times num_{fan}}{100}\right) \\ CFN = TRN_2 - 10\lg\left(1 + \frac{1}{10^{\frac{\alpha}{10}} - 1}\right), \quad \alpha = TRN_2 - TRN_1 \end{cases} \qquad (8)$$

If VFD is installed, $CFN'_{ctrl}$ can be calculated by using (9)

$$CFN'_{ctrl}(n) = CFN + 50\lg\left(X(n)/100\right) \qquad (9)$$

In the equation (6), variables involve top-oil/hot-spot temperature which can be determined based on the principle as below.

Top-oil/hot-spot temperature calculation

Top-oil/hot-spot temperature can be calculated by using the thermal models defined by IEC or IEEE. For example, according to IEC standard, the top-oil temperature $\theta_o$ can be obtained by calculating the incremental top-oil temperature $D\theta_o$ during time internal $Dt$ as shown in Equation (10)

$$\begin{cases} D\theta_{\mathrm{o}}(m) = \dfrac{Dt}{k_{11}\tau_{\mathrm{o}}} \left[ \left( \dfrac{1+R \times K_c(m)^2}{1+R} \right)^x \times \Delta\theta_{\mathrm{or}} - \left( \theta_{\mathrm{o}}(m-1) - \theta_{\mathrm{a}}(m) \right) \right] \\ \theta_{\mathrm{o}}(m) = \theta_{\mathrm{o}}(m-1) + D\theta_{\mathrm{o}}(m) \end{cases} \tag{10}$$

where:

$R$ is the ratio of load losses at rated current to no load losses;
$K_c$ is the corrected loading ratio
$\Delta\theta_{\mathrm{or}}$ is the top-oil temperature rise in steady state at rated losses (no load losses + load losses)
$\theta_a$ is the ambient temperature
$k_{11}$ is the thermal model constant
$\tau_o$ is the average oil time constant
$x$ is the exponential power of total losses versus top-oil temperature rise (oil exponent)
$m$ is number of the time interval for temperature calculation
And the hot-spot temperature can be further calculated by using equation (11).

$$\begin{cases} D\Delta\theta_{h1}(m) = \dfrac{Dt}{k_{22}\tau_w} \left[ k_{21} \times \Delta\theta_{\mathrm{hr}}K(m)^y - \Delta\theta_{h1}(m-1) \right] \\ D\Delta\theta_{h2}(m) = \dfrac{Dt}{(1/k_{22})\tau_o} \left[ (k_{21}-1) \times \Delta\theta_{\mathrm{hr}}K(m)^y - \Delta\theta_{h2}(m-1) \right] \\ \Delta\theta_h(m) = \Delta\theta_{h1}(m-1) + D\Delta\theta_{h1}(m) - \Delta\theta_{h2}(m-1) - D\Delta\theta_{h2}(m) \\ \theta_h(m) = \theta_o(m) + \Delta\theta_h(m) \end{cases} \tag{11}$$

where:

$\Delta\theta_{\mathrm{hr}}$ is the hot-spot to top-oil gradient at rated current
$k_{21}/k_{22}$ is the thermal model constant
$\tau_w$ is the winding time constant
$y$ is the exponential power of current versus winding temperature rise (winding exponent)
$\Delta\theta_{h1}$ and $\Delta\theta_{h2}$ are two interim variables to calculate the hot-spot temperature rise
$D\Delta\theta_{h1}$ and $D\Delta\theta_{h2}$ are the incremental change of $\Delta\theta_{h1}$ and $\Delta\theta_{h2}$ during time period $Dt$

It should be noticed that in order to ensure the accuracy of the IEC differential thermal model, the maximum $Dt$ for temperature calculation should not exceed ½ of the minimum time constant of the thermal model.

The initialization can be done only once at the very beginning of the optimization, or at every time interval of the optimization if the top-oil and/or hot-spot temperature measurement is available.

Preferably, loading ratio should be corrected when only partial cooling capacity is put into operation for ONAF transformer. The correction equation is shown in (12), where $K$ is the measured or the forecast loading ratio (load current/rated current), X is the cooling capacity, $S_0$ is the ratio of the transformer capacity in ONAN working condition to ONAF working condition, and $K_c$ is the corrected loading ratio.

$$K_c = \frac{K}{1-(1-X)(1-S_0)}$$

(12)

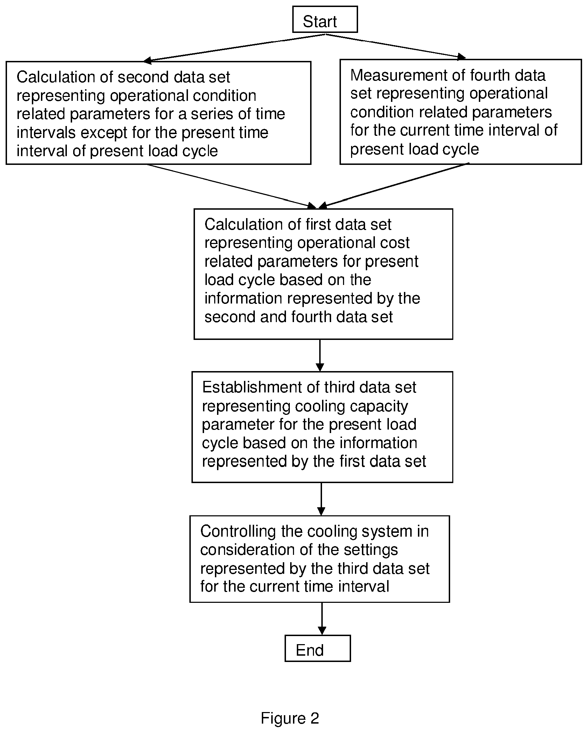

Figure 2 illustrates a method for controlling cooling system of a power equipment according to another embodiment of present invention. As compared with the embodiment according to figure 1, the embodiment of figure 2 is different in that measured ambient temperature and loading ratio can be used for the first time interval in the load cycle, and the forecast and/or historical ambient temperature and loading ratio can be used for the rest time intervals in the load cycle. In particular, instead of considering the second data set second data set representing the operational condition related parameters *AmbientTemperature, LoadingLevel* of figure 1, it uses another second data set and a fourth data set. The another second data set represents operational condition related parameters for the power equipment forecasted for a series of time intervals of present load cycle, where the present load cycle comprises current time interval and the series of time intervals scheduled afterwards, and the fourth data set represents operational condition related parameters for the power equipment for the current time interval of the present load cycle. For example, the fourth data set may be output values of measuring the operational condition related parameters for the power equipment at the current time interval of the present load cycle. In this alternative embodiment, for the present load cycle, the determination of the first data set based on a real-time measurement of ambient temperature and loading ratio for the first time interval in the load cycle is helpful for increasing the accuracy of the first data set in terms of representation of the operational cost related parameter, thus a more accurate cooling optimization approach can be achieved.

Below is described an exemplary system for controlling cooling system of a power equipment using data processing device. The system includes a data processing device, which works together with a memory unit.

The system particularly the data processing device is adapted for obtaining the first data set representing operational cost related parameters specific to the power equipment and its cooling system for a series of time intervals of present load cycle and obtaining the second data set representing operational condition related parameters for the power equipment forecasted for a series of time intervals of present load cycle, for the particular power equipment and its cooling system to be evaluated. The memory unit is adapted for storing the second data set.

For each data set, the system automatically in consideration of the parameters represented by the first data set and the second data set, through knowledge-based predetermined numerical and/or logical linkages, establishing the third data set representing cooling capacity parameters for the cooling system at the series of time intervals of the present load cycle according to criteria for operational cost optimization of the power equipment and its cooling system for the present load cycle. One single overall evaluation parameter (the third data set) is determined by the system resulting from the established evaluation parameters through knowledge-based predetermined numerical linkages (cf. figure 1), and in the present load cycle, the system controls the cooling system to operate at the cooling capacity parameters at the series of time intervals represented by the established third data set. Alternatively, the system may further include a measurement unit, being adapted for measuring the operational condition related parameters for the power equipment at the current time interval of the present load cycle, which are represented by the third data set. One single overall evaluation parameter (the third data set) is determined by the system resulting from the established evaluation parameters through knowledge-based predetermined numerical linkages (cf. figure 2), and during a period in the current time interval of the present load cycle, it controls the cooling system to operate at the cooling capacity parameter of the current time interval represented by the established third data set. Though the present invention has been described on the basis of some preferred embodiments, those skilled in the art should appreciate that those embodiments should by no way limit the scope of the present invention. Without departing from the concept of the present invention, any variations and modifications to the embodiments should be within the apprehension of those with ordinary knowledge and skills in the art, and therefore fall in the scope of the present invention which is defined by the accompanied claims.

**Claims**

1. A method for controlling cooling system of a power transformer, including:

   a) obtaining a first data set representing operational cost related parameters specific to the power transformer and its cooling system forecasted for a series of time intervals of present load cycle in consideration of a second data set representing operational condition related parameters for the power transformer forecasted for a series of time intervals of present load cycle;
   b) in consideration of the parameters represented by the first data set, through knowledge-based predetermined numerical and/or logical linkages, establishing a third data set representing cooling capacity parameters for the cooling system at the series of time intervals of the present load cycle according to criteria for operational cost optimization of the power transformer and its cooling system for the present entire load cycle;
wherein the present load cycle comprises a current time interval and the series of time intervals scheduled afterwards, wherein correlations between different time intervals are considered; and
c) in the present load cycle, controlling the cooling system to operate at the cooling capacity parameters at the series of time intervals represented by the established third data set.

2. The method according to claim 1, wherein

the third data set further represents cooling capacity parameters for the cooling system at the current time interval, the first data set is obtained in further consideration of a fourth data set representing operational condition related parameters for the power transformer for the current time interval of the present load cycle, and controlling the cooling system is performed during a period in the current time interval of the present load cycle.

3. The method according to claim 2, further including:
measuring the operational condition related parameters for the power transformer at the current time interval of the present load cycle, which are represented by the fourth data set.

4. The method according to any of the preceding claims, further including:

for the second data set, the parameters are output values of a processing of those in history; and
storing the second data set.

5. The method according to claim 4, wherein:
the history covers a period of time of previous load cycle.

6. The method according to any of preceding claims, wherein:

the operational cost related parameters specific to the power transformer and its cooling system are concerned with power loss of them, the power transformer lifecycle cost and noise reduction cost for the cooling system; and
the operational condition related parameter for the power transformer is concerned with ambient temperature and loading level.

7. A system for controlling cooling system of a power transformer, which has at least one data processing device, wherein the data processing device is configured for:

obtaining a first data set representing operational cost related parameters specific to the power transformer and its cooling system forecasted for a series of time intervals of present load cycle in consideration a second data set representing operational condition related parameters for the power transformer forecasted for a series of time intervals of present load cycle;
in consideration of the parameters represented by the first data, through knowledge-based predetermined numerical and/or logical linkages, establishing a third data set representing cooling capacity parameters for the cooling system at the series of time intervals of the present load cycle according to criteria for operational cost optimization of the power transformer and its cooling system for the present load cycle;
wherein the present load cycle comprises a current time interval and the series of time intervals scheduled afterwards, wherein correlations between different time intervals are considered; and
in the present load cycle, controlling the cooling system to operate at the cooling capacity parameters at the series of time intervals represented by the established third data set.

8. The system according to claim 7, wherein

the present load cycle comprises a current time interval and the series of time intervals scheduled afterwards, the third data set further represents cooling capacity parameters for the cooling system at the current time interval, the first data set is obtained in further consideration of a fourth data set representing operational condition related parameters for the power transformer for the current time interval of the present load cycle, and controlling the cooling system is performed during a period in the current time interval of the present load cycle.

9. The system according to claim 8, further including:
a measurement unit, being adapted for measuring the operational condition related parameters for the power transformer at the current time interval of the present load cycle, which are represented by the third data set.

10. The system according to any of the claims 7 to 9, further including:

   a memory unit, being adapted for storing the second data set;
   wherein:
   for the second data set, the parameters are output values of a processing of those in history.

11. The system according to claim 10, wherein:
   the history covers a period of time of previous load cycle.

12. The system according to any of claims 7 to 11, wherein:

   the operational cost related parameters specific to the power transformer and its cooling system are concerned with power loss of them, the power transformer lifecycle cost and noise reduction cost for the cooling system; and the operational condition related parameter for the power transformer is concerned with ambient temperature and loading level.


**Patentansprüche**

1. Ein Verfahren zum Steuern eines Kühlsystems eines Leistungstransformators, wobei das Verfahren die folgenden Schritte aufweist:

   a) Erhalten eines ersten Datensatzes, der Betriebskostenparameter repräsentiert, die für den Leistungstransformator und sein Kühlsystem typisch sind, die für eine Reihe von Zeitintervallen eines gegenwärtigen Lastzyklus unter Berücksichtigung eines zweiten Datensatzes prognostiziert werden, der Betriebszustandsparameter für den Leistungstransformator repräsentiert, die für eine Reihe von Zeitintervallen eines gegenwärtigen Lastzyklus prognostiziert werden;
   b) unter Berücksichtigung der Parameter, die durch den ersten Datensatz repräsentiert werden, durch wissensbasierte vorgegebene numerische und/oder logische Verknüpfungen Erstellen eines dritten Datensatzes, der Kühlkapazitätsparameter für das Kühlsystem für die Reihe von Zeitintervallen des gegenwärtigen Lastzyklus entsprechend den Kriterien für eine Betriebskostenoptimierung des Leistungstransformators und seines Kühlsystems für den gesamten gegenwärtigen Lastzyklus repräsentiert;
   wobei der gegenwärtige Lastzyklus ein aktuelles Zeitintervall und die Reihe von Zeitintervallen, die danach vorgesehen sind, aufweist, wobei Korrelationen zwischen verschiedenen Zeitintervallen berücksichtigt werden; und
   c) im aktuellen Lastzyklus Steuern des Kühlsystems, so dass es mit den Kühlkapazitätsparametern in der Reihe von Zeitintervallen betrieben wird, die durch den erstellten dritten Datensatz repräsentiert werden.

2. Das Verfahren nach Anspruch 1, wobei

   der dritte Datensatz ferner Kühlkapazitätsparameter für das Kühlsystem im aktuellen Zeitintervall repräsentiert, der erste Datensatz ferner unter Berücksichtigung eines vierten Datensatzes erhalten wird, der Betriebszustandsparameter für den Leistungstransformator für das aktuelle Zeitintervall des gegenwärtigen Lastzyklus repräsentiert, und
   das Steuern des Kühlsystems während einer Periode im aktuellen Zeitintervall des gegenwärtigen Lastzyklus ausgeführt wird.

3. Das Verfahren nach Anspruch 2, das ferner den folgenden Schritt aufweist:
   Messen der Betriebszustandsparameter für den Leistungstransformator im aktuellen Zeitintervall des gegenwärtigen Lastzyklus, die durch den vierten Datensatz repräsentiert werden.

4. Das Verfahren nach einem der vorhergehenden Ansprüche, das ferner den folgenden Schritt aufweist:

   für den zweiten Datensatz sind die Parameter Ausgabewerte einer Verarbeitung von historischen Daten;
   Speichern des zweiten Datensatzes.

5. Das Verfahren nach Anspruch 4, wobei:
die Historie eine zeitliche Periode eines früheren Lastzyklus abdeckt.

6. Das Verfahren nach einem der vorhergehenden Ansprüche, wobei:

die Betriebskostenparameter, die für den Leistungstransformator und sein Kühlsystem typisch sind, Leistungsverluste, Leistungstransformator-Lebenszykluskosten und Geräuschreduktionskosten für das Kühlsystem berücksichtigen; und
der Betriebszustandsparameter für den Leistungstransformator die Umgebungstemperatur und die Laststufe berücksichtigt.

7. Ein System zum Steuern eines Kühlsystems eines Leistungstransformators, der wenigstens eine Datenverarbeitungsvorrichtung hat, wobei die Datenverarbeitungsvorrichtung konfiguriert ist, die folgenden Schritte auszuführen:

Erhalten eines ersten Datensatzes, der Betriebskostenparameter repräsentiert, die für den Leistungstransformator und sein Kühlsystem typisch sind, die für eine Reihe von Zeitintervallen eines gegenwärtigen Lastzyklus unter Berücksichtigung eines zweiten Datensatzes prognostiziert werden, der Betriebszustandsparameter für den Leistungstransformator repräsentiert, die für eine Reihe von Zeitintervallen eines gegenwärtigen Lastzyklus prognostiziert werden; unter Berücksichtigung der Parameter, die durch die ersten Daten repräsentiert werden, durch wissensbasierte vorgegebene numerische und/oder logische Verknüpfungen, Erstellen eines dritten Datensatzes, der Kühlkapazitätsparameter für das Kühlsystem für die Reihe von Zeitintervallen des gegenwärtigen Lastzyklus entsprechend den Kriterien für eine Betriebskostenoptimierung des Leistungstransformators und seines Kühlsystems für den gegenwärtigen Lastzyklus repräsentiert;
wobei der gegenwärtige Lastzyklus ein aktuelles Zeitintervall und die Reihe von Zeitintervallen, die danach vorgesehen sind, aufweist, wobei Korrelationen zwischen verschiedenen Zeitintervallen berücksichtigt werden; und
im aktuellen Lastzyklus Steuern des Kühlsystems, so dass es mit den Kühlkapazitätsparametern in der Reihe von Zeitintervallen betrieben wird, die durch den erstellten dritten Datensatz repräsentiert werden.

8. Das System nach Anspruch 7, wobei

der gegenwärtige Lastzyklus ein aktuelles Zeitintervall und die Reihe von Zeitintervallen, die danach vorgesehen sind, aufweist,
der dritte Datensatz ferner Kühlkapazitätsparameter für das Kühlsystem im aktuellen Zeitintervall repräsentiert,
der erste Datensatz ferner unter Berücksichtigung eines vierten Datensatzes erhalten wird, der Betriebszustandsparameter für den Leistungstransformator für das aktuelle Zeitintervall des gegenwärtigen Lastzyklus repräsentiert, und
das Steuern des Kühlsystems während einer Periode im aktuellen Zeitintervall des gegenwärtigen Lastzyklus ausgeführt wird.

9. Das System nach Anspruch 8, das ferner Folgendes aufweist:
eine Messeinheit, die ausgelegt ist, die Betriebszustandsparameter für den Leistungstransformator im aktuellen Zeitintervall des gegenwärtigen Lastzyklus, die durch den dritten Datensatz repräsentiert werden, zu messen.

10. Das System nach einem der Ansprüche 7 bis 9, das ferner Folgendes aufweist:

eine Speichereinheit, die ausgelegt ist, den zweiten Datensatz zu speichern;
wobei:
für den zweiten Datensatz sind die Parameter Ausgabewerte einer Verarbeitung von historischen Daten.

11. Das System nach Anspruch 10, wobei:
die Historie eine zeitliche Periode eines früheren Lastzyklus abdeckt.

12. Das System nach einem der Ansprüche 7 bis 11, wobei:

die Betriebskostenparameter, die für den Leistungstransformator und sein Kühlsystem typisch sind, Leistungsverluste, Leistungstransformator-Lebenszykluskosten und Geräuschreduktionskosten für das Kühlsystem berücksichtigen; und

der Betriebszustandsparameter für den Leistungstransformator die Umgebungstemperatur und die Laststufe berücksichtigt.

**Revendications**

1. Un procédé de commande d'un système de refroidissement d'un transformateur de puissance, comportant :

   a) l'obtention d'un premier ensemble de données représentant des paramètres liés aux coûts de fonctionnement propres au transformateur de puissance et à son système de refroidissement, prédits pour une série d'intervalles de temps d'un cycle de charge actuel compte tenu d'un deuxième ensemble de données représentant des paramètres liés aux conditions de fonctionnement pour le transformateur de puissance, prédits pour une série d'intervalles de temps d'un cycle de charge actuel ;
   b) compte tenu des paramètres représentés par le premier ensemble de données, au moyen de liens numériques et/ou logiques prédéterminés basés sur la connaissance, l'établissement d'un troisième ensemble de données représentant des paramètres de capacité de refroidissement pour le système de refroidissement à la série d'intervalles de temps du cycle de charge actuel selon des critères d'optimisation des coûts de fonctionnement du transformateur de puissance et de son système de refroidissement pour le cycle de charge actuel tout entier ; le cycle de charge actuel comprenant un intervalle de temps courant et la série d'intervalles de temps prévus par la suite, des corrélations entre différents intervalles de temps étant prises en compte ; et
   c) dans le cycle de charge actuel, la commande du système de refroidissement pour le faire fonctionner aux paramètres de capacité de refroidissement à la série d'intervalles de temps représentés par le troisième ensemble de données établi.

2. Le procédé selon la revendication 1, dans lequel

   le troisième ensemble de données représente en outre des paramètres de capacité de refroidissement pour le système de refroidissement à l'intervalle de temps courant,
   le premier ensemble de données est obtenu compte tenu en outre d'un quatrième ensemble de données représentant des paramètres liés aux conditions de fonctionnement pour le transformateur de puissance pour l'intervalle de temps courant du cycle de charge actuel, et
   la commande du système de refroidissement est réalisée durant une période dans l'intervalle de temps courant du cycle de charge actuel.

3. Le procédé selon la revendication 2, comportant en outre :
   la mesure des paramètres liés aux conditions de fonctionnement pour le transformateur de puissance à l'intervalle de temps courant du cycle de charge actuel, lesquels sont représentés par le quatrième ensemble de données.

4. Le procédé selon l'une quelconque des revendications précédentes, comportant en outre :

   pour le deuxième ensemble de données, les paramètres sont des valeurs de sortie d'un traitement de ceux dans un historique ; et
   le stockage du deuxième ensemble de données.

5. Le procédé selon la revendication 4, dans lequel :
   l'historique couvre une période de temps d'un cycle de charge précédent.

6. Le procédé selon l'une quelconque des revendications précédentes, dans lequel :

   les paramètres liés aux coûts de fonctionnement propres au transformateur de puissance et à son système de refroidissement ont trait à la perte de puissance de ceux-ci, aux coûts du cycle de vie du transformateur de puissance et aux coûts de réduction du bruit pour le système de refroidissement ; et
   le paramètre lié aux conditions de fonctionnement pour le transformateur de puissance a trait à la température ambiante et au niveau de charge.

7. Un système de commande d'un système de refroidissement d'un transformateur de puissance, pourvu d'au moins un dispositif de traitement de données, le dispositif de traitement de données étant configuré pour :

obtenir un premier ensemble de données représentant des paramètres liés aux coûts de fonctionnement propres au transformateur de puissance et à son système de refroidissement, prédits pour une série d'intervalles de temps d'un cycle de charge actuel compte tenu d'un deuxième ensemble de données représentant des paramètres liés aux conditions de fonctionnement pour le transformateur de puissance, prédits pour une série d'intervalles de temps d'un cycle de charge actuel ;

compte tenu des paramètres représentés par les premières données, au moyen de liens numériques et/ou logiques prédéterminés basés sur la connaissance, établir un troisième ensemble de données représentant des paramètres de capacité de refroidissement pour le système de refroidissement à la série d'intervalles de temps du cycle de charge actuel selon des critères d'optimisation des coûts de fonctionnement du transformateur de puissance et de son système de refroidissement pour le cycle de charge actuel ;

le cycle de charge actuel comprenant un intervalle de temps courant et la série d'intervalles de temps prévus par la suite, des corrélations entre différents intervalles de temps étant prises en compte ; et

dans le cycle de charge actuel, commander le système de refroidissement pour le faire fonctionner aux paramètres de capacité de refroidissement à la série d'intervalles de temps représentés par le troisième ensemble de données établi.

8. Le système selon la revendication 7, dans lequel

le cycle de charge actuel comprend un intervalle de temps courant et la série d'intervalles de temps prévus par la suite,

le troisième ensemble de données représente en outre des paramètres de capacité de refroidissement pour le système de refroidissement à l'intervalle de temps courant,

le premier ensemble de données est obtenu compte tenu en outre d'un quatrième ensemble de données représentant des paramètres liés aux conditions de fonctionnement pour le transformateur de puissance pour l'intervalle de temps courant du cycle de charge actuel, et

la commande du système de refroidissement est réalisée durant une période dans l'intervalle de temps courant du cycle de charge actuel.

9. Le système selon la revendication 8, comportant en outre :

une unité de mesure, adaptée à mesurer les paramètres liés aux conditions de fonctionnement pour le transformateur de puissance à l'intervalle de temps courant du cycle de charge actuel, lesquels sont représentés par le troisième ensemble de données.

10. Le système selon l'une quelconque des revendications 7 à 9, comportant en outre :

une unité de mémoire, adaptée à stocker le deuxième ensemble de données ;

pour le deuxième ensemble de données, les paramètres étant des valeurs de sortie d'un traitement de ceux dans un historique.

11. Le système selon la revendication 10, dans lequel :

l'historique couvre une période de temps d'un cycle de charge précédent.

12. Le système selon l'une quelconque des revendications 7 à 11, dans lequel :

les paramètres liés aux coûts de fonctionnement propres au transformateur de puissance et à son système de refroidissement ont trait à la perte de puissance de ceux-ci, aux coûts du cycle de vie du transformateur de puissance et aux coûts de réduction du bruit pour le système de refroidissement ; et

le paramètre lié aux conditions de fonctionnement pour le transformateur de puissance a trait à la température ambiante et au niveau de charge.

```
                    ┌──────────────┐
                    │    Start     │
                    └──────┬───────┘
                           │
                           ▼
 ┌─────────────────────────────────────────┐
 │ Calculation of second data set          │
 │ representing operational                │
 │ condition related parameters for        │
 │ present load cycle                      │
 └─────────────────────┬───────────────────┘
                       │
                       ▼
 ┌─────────────────────────────────────────┐
 │ Calculation of first data set           │
 │ representing operational cost           │
 │ related parameters for present          │
 │ load cycle based on the                 │
 │ information represented by the          │
 │ second data set                         │
 └─────────────────────┬───────────────────┘
                       │
                       ▼
 ┌─────────────────────────────────────────┐
 │ Establishment of third data set         │
 │ representing cooling capacity           │
 │ parameter for the present load          │
 │ cycle based on the information          │
 │ represented by the first data set       │
 └─────────────────────┬───────────────────┘
                       │
                       ▼
 ┌─────────────────────────────────────────┐
 │ Controlling the cooling system in       │
 │ consideration of the settings           │
 │ represented by the third data set       │
 │ for the present load cycle              │
 └─────────────────────┬───────────────────┘
                       │
                       ▼
                ┌──────────────┐
                │     End      │
                └──────────────┘
```

Figure 1

Start

Calculation of second data set
representing operational condition
related parameters for a series of time
intervals except for the present time
interval of present load cycle

Measurement of fourth data
set representing operational
condition related parameters
for the current time interval of
present load cycle

Calculation of first data set
representing operational cost
related parameters for present
load cycle based on the
information represented by the
second and fourth data set

Establishment of third data set
representing cooling capacity
parameter for the present load
cycle based on the information
represented by the first data set

Controlling the cooling system in
consideration of the settings
represented by the third data set
for the current time interval

End

Figure 2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2015058354 A

- US 2011066298 A1